(19) Europäisches Patentamt
European Patent Office
Office européen des brevets

(11) EP 0 933 873 A1

(12) **EUROPEAN PATENT APPLICATION**

(43) Date of publication:
04.08.1999 Bulletin 1999/31

(51) Int. Cl.⁶: H03K 17/96

(21) Application number: 98810067.3

(22) Date of filing: 30.01.1998

(84) Designated Contracting States:
AT BE CH DE DK ES FI FR GB GR IE IT LI LU MC
NL PT SE
Designated Extension States:
AL LT LV MK RO SI

(71) Applicant: Dynalab AG
5634 Merenschwand (CH)

(72) Inventors:
• Buehlmann, Albert
5603 Staufen (CH)
• Iten, Thomas
6300 Zug (CH)

(74) Representative:
Ritscher, Thomas, Dr.
RITSCHER & SEIFERT
Patentanwälte
Forchstrasse 452
Postfach
8029 Zürich (CH)

(54) **Piezoelectric keyboard**

(57) A keyboard suitable for use as an input device for electronic data comprises a plurality of keys arranged in an array formed of at least two lines $L_1, L_2$ and at least two columns $C_1, C_2$; each key comprises a piezoelectric element (11...44) capable of generating an electric charge when operating the corresponding key; all keys are connected both to a common first electrode means as well as to a second electrode means so that upon actuation of a key of the keyboard an electric charge or signal generated by the actuated key is produced which is indicative of the position of the key within the keyboard; each piezoelectric elements comprises at least two segments and each of these segments is connected separately to the second electrode means.

Fig. 1

**Description**

FIELD OF THE INVENTION

1. Technical Background

The present invention generally relates to the art of producing electronic control signals by means of a plurality of keys and specifically to a data input device of the type known as a piezoelectric keyboard, i. e. a device comprising a plurality of pressure-sensitive keys, each of which produces an electric signal which is specific for the location of each key.

Such keyboards have many uses, such as for control of the operation of machines or for triggering the action of a dispensing device.

2. Prior Art

Piezoelectric keyboards and typical uses thereof have been known for some time as explained in our U.S. patent 5 374 449 and the references cited therein. Various types of such keyboards are available commercially, typically for input of data into automated dispensing devices, such as for automated tellers, for operation of self-service gasoline stations, or control of machinery.

An outstanding advantage of such a keyboard is the fact that it has virtually no moving parts - aside from the minute change needed for compression of the piezoelectric element - and can be assembled to form a very compact and rugged data input device that can withstand even most severe conditions of operation.

In practice, such keyboards typically include arrays of 9, 12, 15, 25 or more keys, each of which may be round or rectangular; the keys are generally arranged in a pattern, typically in the form of a rectangular or square array of alphanumeric symbols, such as digits from 0 to 9, operator signs (+, -, /, *), letters or words, such as ENTER, CANCEL, OK, etc..

Each key is formed by a piezoelectric element, typically a thin aggregation of a ceramic piezoelectric material. Upon the impact of pressure, such as exerted by the pressure of a fingertip, the piezoelectric element is capable of generating a charge in order of some microampéres at a voltage of up to 5 Volts or more.

However, for operating a piezoelectric keyboard, it is the location of each key, i.e. each current generator, rather than the exact magnitude of the current formed that is of interest for practical use, notably since operation should not be significantly dependent upon the actual pressure applied manually for key actuation.

For operation, each piezoelectric key - which if compressed acts as a small generator of electricity - must be connected to electrodes. A typical arrangement is that of a sandwich in which the piezoelectric element is in the position of the butter between two electrodes in the position of the bread cuts.

Now, in order to minimize the amount of electrical connections and amplifiers for locating the position of a given key within an array it is known in the art to use a common connection for one electrode of all keys while each second electrode of each key which is part of most commercially available piezoelectric keyboard requires a separate connector.

Accordingly, an array of, for example, 16, 25 or 36 keys requires 16+1, 25+1 and 36+1 electrical connections or leads, respectively. In other words, the number of leads required in commercial piezoelectric keyboards is defined by the formula

$$N = K + 1$$

in which N is the number of leads while K is the number of keys in the array.

In addition, both pin count and the complexity of the microprocessors or chips required for processing the signals by the keyboard will increase with the number of leads. Accordingly, it would be desirable to find a way of reducing both the total number of leads as well as the total number of pin connections of the chip, or chips, connected to the keys, notably for piezoelectric keyboards having at least 16 keys.

Objects and Summary of the Invention

This object and further advantages apparent form the following specification will be obtained, according to the invention, by a keyboard comprising a plurality of operational keys arranged in an array formed of at least two lines and at least two columns, each of said keys comprising a piezoelectric element capable of generating an electrical charge when operating said key; wherein each of said piezoelectric elements is connected both to a common first electrode means and to a second electrode means so that upon actuation of a key of the keyboard an electrical charge or signal generated by the actuated key is produced which is indicative of the position of the key within the keyboard; and wherein each of said piezoelectric elements comprises at least two segments, each of said segments being connected separately to said second electrode means.

Keyboards according to the invention can be produced, according to the invention, by using suitably segmented piezoelectric elements which may be pre-produced and then assembled in a positioning means or by producing the segmented piezoelectric elements in situ by printing as disclosed in our above mentioned U.S. patent 5 374 449.

Brief Discussion of Terms and of Preferred Embodiments of the Invention

The term "piezoelectric means" as used herein is intended to refer to a piezoelectric "element" which is indicative of a specific key of the keyboard and comprises at least two segments. Segmentation could include the piezoelectric layer plus the adjacent electrode or electrodes. However, it is sufficient and preferred for many purposes that one of the contacting electrodes is segmented.

Preferably, all piezoelectric elements are positioned in a common plane. Also, it is preferred for many purposes of the invention that the piezoelectric elements are essentially isomorphic, i.e. have essentially the same geometric shape when viewed vertically to their common plane.

Typically, the elements have a generally circular shape with paired segmented electrodes as a preferred arrangement. In other words, a preferred piezoelectric means or element according to the invention is formed by two and essentially semicircular electrode segments provided on a piezoelectric layer that may but need not be segmented as well. However, the elements may have other shapes including oval, square or generally polygonal forms. The shape of the electrode segments is not believed to be overly critical as long as a sufficient area of contact with the piezoelectric layer is ascertained, and as long as a gap of sufficent width is provided between the electrode segments of each element to avoid direct electric contact between the segments.

Preferably, one co-planar side of each segment is connected to a common or "first electrode means" for common contact with a first side of all of piezoelectric elements or segments; a "second electrode means" is formed by a plurality of electric leads for connection with the segments of the piezoelectric elements. In other words, each piezoelectric element is connected on one of it's sides with a common electrode and to segmented electrodes on the other side.

It is anything but obvious that segmentation and the corresponding increase of electrode contacts provides for a reduction of the leads required for a given array that includes at least 16 keys.

Mathematically expressed, the number of leads of a keyboard according to the invention is

$$N = L + C + 1$$

wherein N is the number of leads, L is the number of lines and C is the number of columns, with the proviso that $L \geq 2$ and $C \geq 2$. In a square array - an array where the number of columns is equal to the number of lines and where each line and each column includes essentially the same number of keys - the number of leads is

$$N = 2\sqrt{K} + 1$$

wherein, again, N is the number of leads while K is the number of keys in the array. Accordingly, while a conventional piezoelectric keyboard of 16, 25 or 36 keys would require 17, 26 and 37 leads, respectively, keyboards according to the invention with the same number of keys in a square array will require only 9, 11 and 13 leads, respectively. Even with a number of keys that cannot be arranged in a square, for example in an array formed by 20 keys arranged in 5 lines and 4 columns, the number of leads in a keyboard according to the invention is only 10 ( N = L + C +1 ) as compared with 21 ( N = K + 1 ).

European patent application 0 203 261 discloses a piezoelectric keyboard in which the electrodes provided on continuous piezoelectric films e.g. made of polyvinylidene fluoride and similar organic polymers, are arranged in columns and lines. However, two mutually superimposed piezoelectric layers are needed and the piezoelectric behaviour of organic piezoelectric materials differs in significant aspects from ceramic piezoelectric elements; it has been found in practice that the behavior of organic piezoelectric films leaves much to be desired. As a consequence, most commercially produced piezoelectric keyboards rely on ceramics rather than on organic piezoelectric elements. Further, the teachings for using continuous films of a piezoelectric material are opposed to those relating to an array of individual piezoelectric elements.

Now, according to a preferred general embodiment of the invention, one (and preferably the first) segment of each key in a given line L is interconnected with one (and preferably the first) segment of each other key in that given line, while one (and preferably the second) segment of each key in a given column is interconnected with one (and preferably the second) segment of each key in that column.

In such a grid-like array, each individual key can be identified by it's $x_n y_m$ designation in which "x" indicates lines and "y" indicates columns while "n" is the line number and "m" is the column number of a given key in the matrix. For example, in a square array of 16 keys, $x_1 y_1$ designates the "first" key positioned in the upper left corner while $x_4 y_1$, $x_4 y_1$ and $x_4 y_4$ designate the keys in the upper right, lower left, and lower right corner, respectively.

Generally speaking, any such grid, pattern or array comprise at least two lines extending in a common first direction, and at least two columns extending in a common second direction; the first common or line direction intersects at an angle of, for example 90° (other angles being possible, of course, as well), with the second or column directions so as to form a grid or matrix; then, each of key in the array has a unique position identified by a line number and a column number.

As will be apparent from this explanation, the invention provides best results for square arrays which achieve maximum reduction of leads when compared with prior art electric keyboards having unitary piezoelectric elements. However, intermediate arrays, e.g. those with differing numbers of lines and columns or and even those with either incompletely filled lines or incompletely filled columns will provide advantages with respect to lead reduction if segmented piezoelectric elements are used for the keyboard.

Electric switching of grid-like arrangements is well known in the art of multiplexing so that no detailed explanation is required. As a matter of principle, actuation of a given key in a keyboard according to the invention will generate one signal for each of its segments, i. e. a "line signal" indicative of the line in which the actuated key is positioned and a "column signal" indicative of the column in which the actuated key is situated.

In this manner, actuation of a key of a keyboard according to the invention will generate a signal which identifies the unique $L_nC_m$ designation of that key.

The type of piezoelectric material for use herein is not believed to be overly critical and various examples can be found in the patents cited above. Piezoelectric materials of the sintered ceramic type are preferred for many purposes including application by printing.

Prefabricated piezoelectric elements in the typical form of small circular disks with a metallic support for assembling in any desired pattern or array can be obtained commercially, e.g. those sold under the trademark SONOX® from Hoechst CeramTec AG, Germany, including piezoelectric elements of the segmented type. Such elements require no additional activation, e.g. polarization. However, if the segmenmted electrodes are formed by printing essentially as disclosed in our US patent 5 374 449, a poling treatment is required after integration or lamination of the constituent layers as disclosed in the said patent. Segmentation may include the piezoelectric layer but may as well be, and preferably is, restricted to segmentation of the electrodes connected with the second electrode means.

Brief Description of the Drawings

The invention will now be discussed in more detail but without limitation with reference to the attached drawings in which:

Figure 1 is a diagrammatic top view of a square 4x4 array of 16 segmented keys with common connecting leads for each line and each column of the array;

Figure 2 is diagrammatic and broken-away cross-sectional view of adjacent piezoelectric segmented elements connected on one side with a common electrode and on the other side with separate connectors for each segment of an element;

Figures 3A - 3C are semi-diagrammatic top views of segmented piezoelectric elements for use in a keyboard according to the invention;

Figures 4A - 4I are semi-diagrammatic top views of layers and layer patterns for use in assembling a keyboard according to the invention.

Discussion of Preferred Embodiments and Examples of the Invention

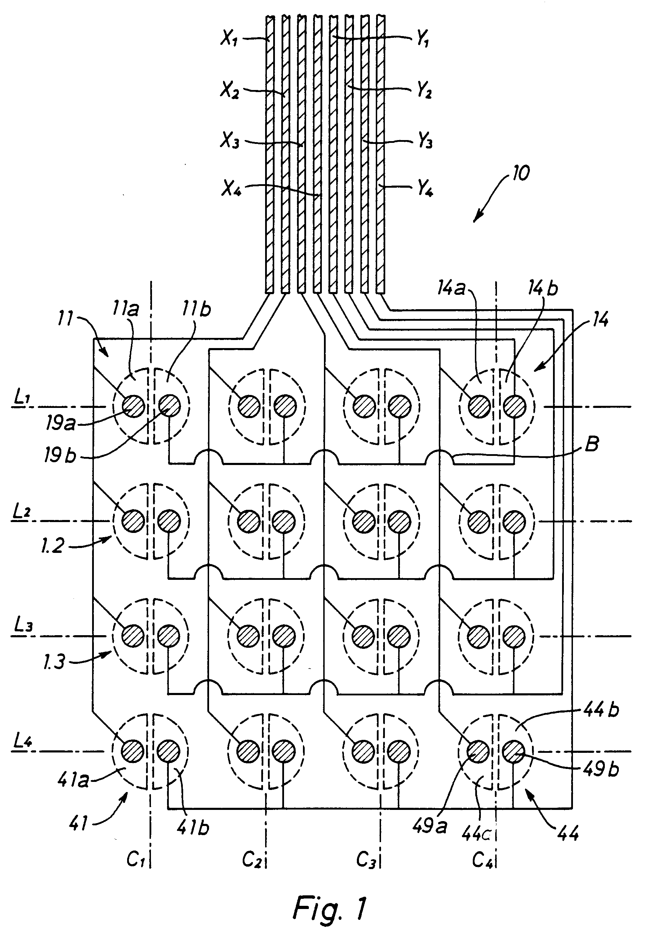

The top view of a pattern of 16 segmented piezoelectric elements arranged as an array 10 in the form of a square of 4 by 4 segmented keys 11 to 44 is illustrated in Fig. 1, and comprises four lines $L_1$ - $L_4$ and four columns $C_1$ - $C_4$.

The four elements or keys 11, 12, 13 and 14 are all positioned in one common line $L_1$ but in four different columns $C_1$, $C_2$, $C_3$, and $C_4$, respectively, and it will be apparent immediately that the reference numbers of the elements or keys shown in Fig.1 are indicative of the unique position number of each element or key 11 - 44 in array 10 by the number of the line as the first digit and the number of the column as the second digit. Thus, for example, key 11 is the key in line 1 and column 1 while key 44 is the key in line 4 of column 4.

According to the invention, each of the elements or keys 11 - 44 comprises two segments indicated by "a" and "b", respectively. For example, segments 11a and 11b are the two segments of key 11 while segments 44a and 44b are the two segments of key 44.

In an array 10 of a keyboard according to the invention, all segments "a" of elements or keys 11, 21, 31, and 41 - in other words, all keys in lines $L_1$-$L_4$ of column $C_1$ - are connected by one and the same connector or lead $x_1$. On the other hand, all segments "b" of the elements or keys 11, 12, 13, and 14 - i.e. all keys in columns $C_1$-$C_4$ of line $L_1$ -are connected by one and the same connector $y_1$. Accordingly, four connectors or leads $x_1$-$x_4$ form the connection of all "a" segments of the keys in columns $C_1$-$C_4$ while four connectors or leads $y_1$-$y_4$ form the connection of all "b" segments of the keys in lines $L_1$-$L_4$.

It is to be emphasized that the column leads $x_1$-$x_4$ and the line leads $y_1$-$y_4$ are not interconnected electrically in the array 10 but pass them in the manner of round "bridges" B, e.g. by way of an layer of an insulating material provided at the points of mutual cross-over.

Each segment 11a,11b - 44a,44b is provided with an electrode 19a,19b - 49a,49b shown in Fig. 1 as a black circular dot. According to a preferred embodiment, the surface area covered by electrodes 19a,19b - 49a,49b is smaller than the adjacent surface of elements 11a,11b - 44a,44b to avoid shorting.

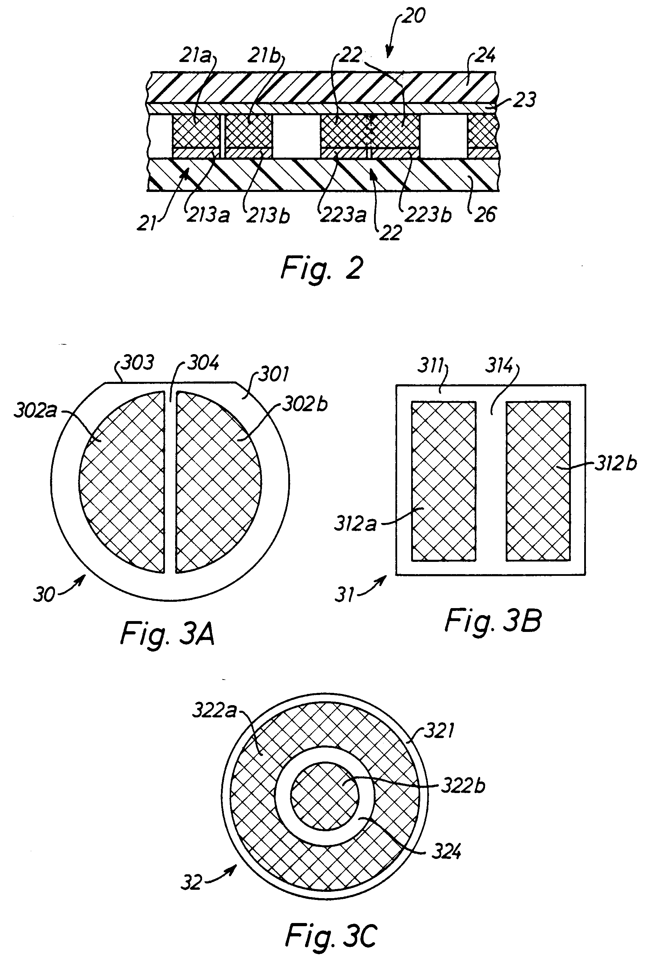

For the purposes of the present specification and claims, the "second electrode means" mentioned above is formed by segment electrodes 19a,19b - 49a,49b plus the coordinated leads $x_1$-$x_4$ and $y_1$-$y_2$. By the same token, the "first electrode means" is formed by the common electrode on the other side of the segments (cf. Fig. 2) plus at least one lead for connecting this common electrode with the operating circuit.

It should be emphasized in this context that larger or smaller arrays including both square as well as non-square arrangements can be provided with segmented electrodes according to the invention; however, the benefits in terms of the reduction of the number of leads and the decreased complexity of the coordinated microprocessors increase with increasing numbers of keys and with square arrays.

In terms of production, both the first and the second electrode means are preferably produced by printing techniques, e.g. the screen printing methods disclosed in our U.S. patent mentioned above, for applying electrically conductive deposits for serving as electrodes 19a,19b - 49a,49b and connectors $x_1$-$x_4$, $y_1$-$y_4$. A more detailed description will be given in the examples.

Fig. 2 illustrates, in an entirely diagrammatic manner, a broken away portion 20, shown in section, of a keyboard according to the invention. Piezoelectric material is indicated in a cross-hatched manner. Two types of segmentation are illustrated: piezoelectric element 21 illustrates the embodiment where both the piezoelectric layer 21a,21b as well as the adjacent electrode 213a,213b are segmented while piezoelectric element 22 comprises an integral piezoelectric layer 22 and a segmented electrode consisting of electrode portions 223a and 223b, it being understood that normally only one type of segmentation will be used in a given keyboard type according to the invention. Regardless of the type of segmentation used, all elements 22,23 are arranged in contact, on one side of each element or segment with a common or first electrode means 23, e.g. an electrically conductive layer (continuous or patterned) between the piezoelectric material and an insulating layer or sheet 24; the first electrode means 23 serves to electrically interconnect all segments of an array; the second electrode means is formed by segment electrodes (only 213a,213b, 223a,223b shown) as well as coordinated connectors or leads (not shown), and an adjacent layer or sheet of an electrically insulating layer 26.

According to the invention, the segments of any given piezoelectric element of the keyboard are connected separately with the second electrode means so that upon operation of a given key one of the segments of the piezoelectric element associated with that key will produce a signal charge which is indicative of the line position of that key in the array, while the other segment of the piezoelectric element of the associated key will produce a signal current which is indicative of the column position of that key in the array.

The piezoelectric elements as well as their segmented electrodes may have various shapes, it being noted that the cross-hatched shading in Figs. 3A - 3C are meant to show segmentation of the electrode in either embodiment, i.e. including, or not, the piezoelectric layer. Fig. 3A - 3C schematically illustrate but three species: element 30 of Fig. 3A comprises an essentially circular substrate 301, e.g. a metallic or, at least, electrically conductive platelet, typically with a diameter of between about 2 and 50 mm with two adhering and essentially semicircular electrode segments 302a, 302b formed of an electrically conductive material; the piezoelectric layer below the electrode segments has a thickness of 0,03 - 2 mm; the separator or gap 304 between the electrode segments is a narrow and essentially straight strip-shaped zone free of conductive material but neither the shape nor the width of gap 304 are believed to be critical. The straight upper portion 303 of the periphery of the piezoelectric element 30, on the other hand, is a preferred feature when using essentially circular piezoelectric elements because this provides a simple means to ascertain the required positioning of the elements when assembling the keyboard and mounting pre-fabricated piezoelectric elements. When using a positioning means of the type explained in more detail below and having perforations of the same shape as the elements it is assured that the segments of the piezoelectric elements are aligned with the corresponding electrode segments.

Fig. 3B shows a diagrammatic top view an essentially square piezoelectric element 31 formed of a thin and electrically conductive substrate 311 provided on top of a layer of piezoelectric material (not visible) with two rectangular segments 312a,312b of electrode material firmly adhering to the piezoelectric layer underneath. Again, a linear gap 314 free of electrode material is provided as a separator but, again, neither shape nor width of gap 314 are believed to be critical.

Fig. 3C shows a diagrammatic top view of another essentially circular piezoelectric element 32 formed by an electrically conductive support 321 having two concentric segments 322a,322b of electrode material (indicated in a cross-hatched manner) adhering to support 321. Gap 324 has the form of a circular annulus and it is apparent that such an embodiment does not require a particular positioning means.

Generally, the shape of the piezoelectric segments can be selected so as to facilitate both production of the piezoelectric elements and assembly of the keyboards. For example, an alternative to applying each segment separately onto a substrate it is within the purview of the invention to first produce an integral piezoelectric layer on the support and subsequently generating a gap by abrading or otherwise removing a strip-like portion of the piezoelectric layer for producing segments.

As will be apparent from this explanation of Fig. 3A-3C, the thickness of the layers and elements shown in Fig. 2 is by no means realistic in that the thickness of the layers has been greatly exaggerated for purposes of illustration. Also, the arrangement of the piezoelectric material on a metallic carrier discussed above is typical for preformed piezoelectric elements, this being no critical feature, however, since - as briefly mentioned above - the piezoelectric segments can as well be produced in situ, i.e. by applying the piezoelectric layer, segmented or not segmented, by way of printing onto a substrate provided with the first or the second electrode means.

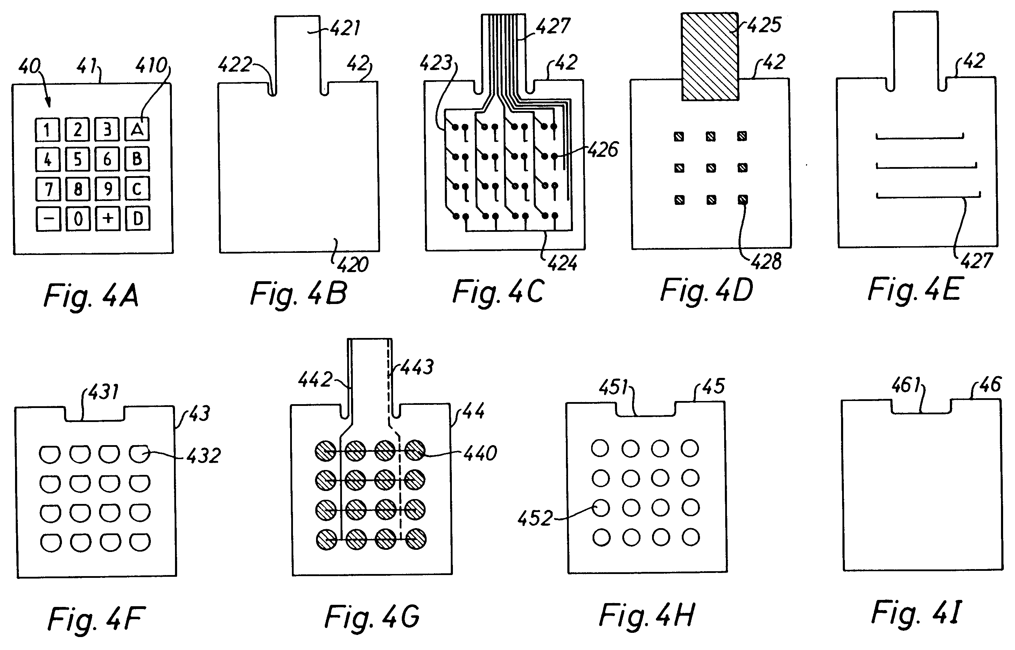

Fig. 4A to 4I are top or bottom views of the layers of an illustrative embodiment of a piezoelectric keyboard according to the invention. The topmost layer from an operative point of view is shown in Fig. 4A and is designated a 41. Typically, this is a protective layer made of a metallic (e.g. aluminum) or organic polymer substance, e.g. a polyester, polyamide, polyalkylene, polycarbonate, polyacetal, or another suitable polymer sheet material having a thickness of typically in the range of from about 0,1 - 5 mm provided at it's top side with a pattern or array 40 to show the position of the keys 410. Pattern 40 can be produced by conventional methods, such as printing, engraving, or etching and coloring. Generally, top layer 41 should have some flexibility to permit selective actuation of the coordinated piezoelectric elements upon the pressure of a finger of the operator onto a key of array 40.

Fig. 4B is a carrier layer 42 for receiving the electrode pattern which forms the second electrode means and is made of an electrically insulating material, typically an organic polymer with a typical thickness in the range of from about 0,01 - 1 mm; its upper side (that adjacent the protective layer 41 in the final assembly) will be connected, e.g. via an adhesive (not shown), to the topside protective layer 41. Connector latch 421 is a protrusion for receiving electrically conductive paths as explained below while the adjacent recesses 422 are intended to increase flexibility of latch 421.

The lower side of substrate 42 is provided with an electrically conductive pattern of the type illustrated in Fig. 4C. The pattern can be applied by printing using a commercial paint consisting of a metallic or pseudo-metallic pigment (silver, copper, nickel, graphite) dispersed in a binder material to produce an electrically conductive residue when dried. Other methods for topically applying an electrically conducting material could be used as well, e.g. galvanic deposition, sputtering, vapor deposition etc.

The conductive pattern is formed by electrodes 426 for separate connection with the segments of each segment pair, by column connections 423, by line connections 424 and by connector leads 427. Obviously, the specific form of the all patterns can be modified to suit the specific needs which depend mainly upon the size of the keyboard, the number of keys, the shape of the electrode segments and other structural parameters.

As is apparent from Fig. 4C, two dot-like electrodes 426 forming an electrode pair are provided for each key, and all first segments of each column of keys are shown to be interconnected by column connectors 423 for each column. The second segments of the keys in each column are interconnected line connectors 424 of which only the lowest line is applied at this stage.

In order to avoid undesired interconnections, an insulating material (indicated in black) is topically applied as illustrated in Fig. 4D, e.g. by printing, onto the conductive pattern shown in Fig. 4C; insulating areas 428 serve to electrically separate the electrical bridges 427 applied in the subsequent step (Fig. 4E) from the column connectors 423 shown in Fig. 4D and forming the rest of the line connectors. as black shapes. Another portion 425 of the insulating material covers leads 427 (Fig. 4C).

Electrically conductive bridges 427 are applied onto the insulating areas (shown ion Fig.4D), e.g. in shapes of the type illustrated in Fig. 4E. Again, application can be effected by printing or any other suitable method for topically applying an electrically conducting material.

The next layer for the final laminate that forms the keyboard is a positioning layer 43 having a thickness substantially equal to the thickness of the prefabricated segmented piezoelectric elements which it will receive, e.g. has a thickness typically in the range of from 0,03 - 2 mm and typically consists of an electrically non conductive material, such as a polymer, e.g. an organic polyester, polyamide, polyalkylene, polycarbonate, polyurethane or a cellulosic material, such as cardboard. It is provided with an array of sixteen perforations 432 shaped in a manner to ascertain proper positioning of a corresponding number of prefabricated isomorphic segmented piezoelectric elements. Recess 431 is another means to improve flexibility of latch 421 (Fig. 4B) when all layers of the keyboard are assembled. An adhesive (not shown) may be provided at one or both sides of positioning layer 43 for connection with adjacent layers 42 and 44.

Upon assembly of the various layers shown in Figs. 4A-4I when producing keyboards according to the invention, segmented piezoelectric elements of the type illustrated in Fig. 3A (not shown in Fig. 4) matching the shape of the perforations 432 of positioning layer 43 are inserted into the recesses formed by the perforations 432 such that the surface of the piezoelectric segments will come into contact with the corresponding electrode pairs illustrated in Figs 1 and 3C. As explained above, safe positioning will be facilitated by suitably matching the shapes of the piezoelectric elements and the perforations. As briefly mentioned above, the thickness of the piezoelectric elements and the thickness of the positioning layer should be about equal to provide for flush mounting.

A separate stratum of the same type and thickness as used for supporting the second electrode means (layer 42 in Fig. 4B) is also use for supporting the first electrode means is provided as illustrated in Fig. 4G. Layer 44 serves this purpose; it's top surface (i.e. that to contact positioning layer 43 in the final keyboard), at least, is provided with an electrically conductive material applied in a topical or continuous manner for contact with the electrically conducting supports of the prefabricated segmented piezoelectric elements provided in the holes of positioning layer 43.

The conductive material can form a continuous coating or be applied topically so as to correspond with the shape of the piezoelectric elements. The pattern of circular patches 440 and one or more connectors 442,443 shown in Fig. 4G is by no means critical and serves merely to minimize the amount of electrically conductive material (e.g. silver paint) that must be applied for common electrical contact with all piezoelectric elements and for providing electrical connection with a processor plus coordinated circuit (not shown).

Now, an optional distancing layer 45, e.g. as illustrated in Fig. 4H, may be provided of the same type as the positioning layer 43 with a pattern of perforations 452 that permit a distinct elastic deformation of the piezoelectric elements when under the impact of manual pressure onto a key. The use of such distancing means for re-enforcing the effectiveness of operation of piezoelectric elements is known in the art, e.g. as disclosed in European patent application No. 0 472 888. The criterion of an effective distancing means for purposes of re-enforcing the piezoelectric effect is that the backside of each piezoelectric element is supported at it's periphery while its more central part is left unsupported. The term "backside" in this connection refers to that side of the piezoelectric element which is opposite to the side turned towards the pressure impact side.

Finally, a backside covering layer as illustrated in Fig. 4I is applied as a base layer.

The layers are now assembled and the segmented piezoelectric elements inserted.

According to a modified method embodiment, the segmented piezoelectric elements are applied by printing in the manner disclosed in Example I of our U.S. patent 5 374 449 except that the piezoelectric layer was applied on the second electrode support layer shown in Fig. 4G after printing of the electrode pattern.

The invention will be further illustrated without limitation by way of the following examples disclosing two methods for producing a keyboard according to the invention in a commercially feasible manner.

EXAMPLE 1

Part A: Protective layer

A print-receptive sheet of aluminium, polycarbonate or other wear-resistant material (gauge 0,5 mm) is printed on one side with a number of keying patterns and cut to shape so as to produce a number of protective layers as illustrated in Fig. 4A; the backside of the sheeting is provided with a commercial overlay adhesive.

Part B: First Electrode Support Layer

(B-1) Another sheet of polyester of the type used in part A but with a thickness of 125 μm is printed with a number of electrode/conductor patterns using a screen printing method and a commercial silver printing ink as shown in Fig. 4C. The printed pattern was air-dried.

(B-2) Next, a pattern of an electrically insulating layer as illustrated in Fig. 4D was applied in a similar manner using a commercial screen printing lacquer.

(B-3) After air-drying as above, connecting bridges as illustrated in Fig. 4E were applied by printing with silver printing ink as above and air-dried.

The sheet was cut to size forming a number of support layers as illustrated in Figs. 4B - 4E.

Part C: Spacer

Commercial cellulosic cardboard or other sheet material with a thickness corresponding to that of the prefabricated piezoelectric elements used was perforated and cut to size according to the shape illustrated in Fig. 4F. The openings for receiving the piezoelectric elements corresponded with the peripheral shape of the piezoelectric elements. Both sides of the positioning layer were coated with an adhesive film as used in part A.

Part D: Second Electrode Support Layer

This layer is made in the same manner as in part B above except that an electrode pattern as shown in Fig. 4G was applied by printing.

Part E: Base adhesive

Spacer layers were produced in the same manner as in part C except that the pattern of perforations was as shown in Fig. 4H and that the diameter of the perforations was 9mm. Both sides of the spacer layer ware coated with the adhesive of part A.

Part F: Base Plate

Plates of metal or plastic as used in part A were cut to size to provide a number of base layers as illustrated in Fig. 4I.

Assembly:

Stacks of layers produced in parts A - C were assembled and compressed; pre-fabricated segmented piezoelectric elements of the type shown in Fig. 3A were inserted into the recesses formed by the perforations 432 of positioning layer (43, Fig. 4F) such that the piezoelectric layers faced the electrodes of layer 42 while the metal support discs at the back of each piezoelectric element closed the recesses.

Then, the stacks were completed each by applying the second electrode layer with the electrode side facing the metal support discs of the piezoelectric elements onto the positioning layer. Next, the distancing layer and finally the base layers were applied. The keyboards are now ready for use.

EXAMPLE 2

Piezoelectric keyboards were produced substantially as in example 1 except that the positioning layer produced in part C was omitted.

Piezoelectric elements having a circular shape and a diameter of about 10 mm were printed onto the second electrode layer produced in part D of Example 1 in the manner disclosed in U.S. patent 5 374 449

The ink was applied topically onto the second support layer (443 in Fig. 4G) in the area of the electrode portions by printing three times with a screen of 43 T (110 mesh T) taking care to avoid formation of air bubbles in the layer. A photographically produced pattern was used to concentrically cover the electrode areas by a margin of about 1 mm. After each printing operation, the applied layer was airdried 30 min at 100°C. Total thickness of the resulting dried piezoelectric film was about 50 μm. Assembly by lamination and poling were effected as disclosed in the aboementioned U.S. Patent.

EXAMPLE 3

Example 2 was repeated except that layer 45 (Fig. 4H) was omitted. Distancing means were applied by printing onto base sheet 46 (Fig. 4I) in a manner similar as explained in Example 2 except that no ceramic piezoelectric material was used in the printing ink.

Various modifications within the scope of the above disclosure will be apparent to those experienced in the art of piezoelectric keyboards. For example, piezoelectric keyboards of the bimorphic type as disclosed in our U.S. patent No. 5 374 449 (incorporated herein by way of reference) could be made with segmented piezoelectric elements could be made. Further, while the use of two segments for each piezoelectric element is preferred for many purposes, special applications might benefit from using piezoelectric elements each having three or more segments.

**Claims**

1. A keyboard comprising a plurality of operational keys arranged in an array formed of at least two lines L and at least two columns C, each of said keys comprising a piezoelectric element capable of generating an electrical charge when operating one of said keys; wherein each of said piezoelectric elements is connected both to a common first electrode means and to a second electrode means such that upon actuation of a key of the keyboard an electrical charge is generated by the actuated key, said signal being indicative of the position of the key within the keyboard; and wherein each of said piezoelectric elements comprises at least two segments, each of said segments being connected separately to said second electrode means.

2. The keyboard of claim 1 wherein said at least two lines L of said array extend in parallel and in a common first direction while said at least two columns C extend in a common second direction; said first and said direction intersecting with each other at an angle of about 90°; each of said keys having a unique position within said array identified by a column number and a line number.

3. The keyboard of claim 2 wherein said array is an essentially square array having substantially the same number of lines and columns.

4. The keyboard of claim 1 wherein said array includes at least about 16 keys.

5. The keyboard of any of claims 1 - 4 wherein one and preferably the first segment of each keys in a given line L is interconnected with one and preferably the first segment of each other key in that given line L , while one and preferably the second segment of each key in a given column C is interconnected with one and preferably the second segment of each key in that column C.

6. The keyboard of any of claims 1 - 5 wherein said piezoelectric elements consist of a ceramic piezoelectric material optionally adhering to a support.

7. The keyboard of claim 6 wherein said support is an electrically conducting layer, e.g. of a metal, and wherein said segments are formed by electrode portions contacting said piezoelectric material.

8. A method of producing a keyboard comprising a plurality of operational keys arranged in an array formed of at least two lines L and at least two columns C, each of said keys comprising a piezoelectric element capable of generating an electrical charge when operating one of said keys; wherein each of said piezoelectric elements is connected both to a common first electrode means and to a second electrode means such that upon actuation of a key of the keyboard an electrical charge is generated by the actuated key, said signal being indicative of the position of the key within the keyboard; and wherein each of said piezoelectric elements comprises at least two segments, each of said segments being connected separately to said second electrode means.

9. The method of claim 8 wherein said segmented piezoelectric elements consist of a pre-fabricated ceramic piezoelectric material optionally adhering to an electrically conducting support.

10. The method of claim 8 wherein said segmented piezoelectric elements are produced by printing onto an electrically conducting support.

Fig. 1

Fig. 2

Fig. 3A

Fig. 3B

Fig. 3C

Fig. 4E

Fig. 4I

Fig. 4D

Fig. 4H

Fig. 4C

Fig. 4B

Fig. 4G

Fig. 4A

Fig. 4F

European Patent Office

**EUROPEAN SEARCH REPORT**

Application Number

EP 98 81 0067

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| X | DE 39 27 306 A (PENNWALT CORP) 22 February 1990<br>* column 7, line 23 - line 28 *<br>* column 8, line 47 - column 9, line 17 *<br>* figures 4,8 *<br>--- | 1-3,5,6,8,9 | H03K17/96 |
| A | EP 0 512 124 A (SCHEIDT & BACHMANN GMBH) 11 November 1992<br>* column 3, line 11 - column 4, line 17; figures *<br>--- | 6,7,9,10 | |
| A | EP 0 210 386 A (SCHENK & CO) 4 February 1987<br>* column 4, line 31 - line 46 *<br>* column 5, line 7 - line 31 *<br>* figures 1-4 *<br>----- | 1,7,9,10 | |
| | | | **TECHNICAL FIELDS SEARCHED (Int.Cl.6)**<br><br>H03K |

The present search report has been drawn up for all claims

| Place of search | Date of completion of the search | Examiner |
|---|---|---|
| THE HAGUE | 17 June 1998 | D/L PINTA BALLE.., L |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)